Europäisches Patentamt

European Patent Office

Office européen des brevets

(19)

(11) Publication number: **0 121 824**
**B1**

# EUROPEAN PATENT SPECIFICATION

(12)

(45) Date of publication of patent specification: **02.01.91**

(51) Int. Cl.⁵: **H 01 P 1/30**

(21) Application number: **84102852.5**

(22) Date of filing: **15.03.84**

(54) **Microwave oscillator.**

(30) Priority: **16.03.83 JP 44995/83**

(43) Date of publication of application:
**17.10.84 Bulletin 84/42**

(45) Publication of the grant of the patent:
**02.01.91 Bulletin 91/01**

(84) Designated Contracting States:
**DE FR GB IT**

(56) References cited:
**EP-A-0 044 941**

**Patent Abstracts of Japan vol. 7, no. 52, 2 March
1983 & JP-A-57-201307**

**Patent Abstracts of Japan vol. 6, no. 182, 18
September 1982 & JP-A-57-97205**

**Patent Abstracts of Japan vol. 6, no. 251, 10
December 1982 & JP-A-57-150203**

**Patent Abstracts of Japan vol. 2, no. 75, 14 June
1978 page 3013E78 & JP-A-53-41185**

(73) Proprietor: **NEC CORPORATION
7-1, Shiba 5-chome Minato-ku
Tokyo 108-01 (JP)**

(72) Inventor: **Mizumura, Motoo
c/o NEC Corporation 33-1, Shiba 5-chome
Minato-ku Tokyo (JP)**
Inventor: **Wada, Kenzo
c/o NEC Corporation 33-1, Shiba 5-chome
Minato-ku Tokyo (JP)**

(74) Representative: **Vossius & Partner
Siebertstrasse 4 P.O. Box 86 07 67
D-8000 München 86 (DE)**

## Description

### Background of the invention

The present invention relates to a microwave oscillator and, more particularly, to a dielectric-controlled type integrated oscillator which is furnished with a semiconductor active element chip and stabilized in oscillation frequency by a dielectric resonator.

In a dielectric-controlled integrated oscillator of the type described, it is a usual practice to mount a substrate made of a material having a high dielectric constant on a bottom wall inside a metal chassis of a housing, and a semiconductor active element chip and a dielectric resonator on the substrate, the active element chip and dielectric resonator being electromagnetically coupled to each other. The top of the housing is closed by a cover plate to complete a single oscillator package. Generally, the semiconductor active element chip in use has to be protected from the atmospheric air (particularly moisture) by hermetically sealing the oscillator package. Such is usually implemented by soldering or otherwise sealingly connecting the metal chassis to the cover plate after the installation of the substrate, active element chip and the like in the chassis.

A problem encountered with the above-described type of prior art oscillator is that when the oscillator in the sealed package has undergone a change in oscillation frequency due to aging, particularly temperature variation or the like, it is practically impossible to adjust the oscillation frequency. Additionally, it is difficult, if not impossible, to set up a desired frequency while absorbing frequency deviation due to dimensional tolerance of the oscillator before the sealed confinement.

As discussed above, the prior art dielectric-controlled type integrated oscillator has failed to reconcile two major requirements to each other, i.e. hermetic or air-tight sealing and frequency adjustment.

JP—A—57-201307 teaches an IC oscillator in which a dielectric resonator is passed throughout an opening of a microstrip circuit and mounted on the insulating board. The board is mounted on and shielded by the stem. This prior art oscillator needs an insulating board for shielding purposes in addition to the microstrip circuit which is provided with an opening to be coupled with the resonator; this results in a complicated construction.

EP—A1—0 044 941 discloses a microstrip circuit on which a microstrip line, a stub line and an FET are mounted. In the microstrip circuit as disclosed, the adjustng means adjust the wave resistance of the microstrips by changing, for example, the capacitance at the open end of the stub line through four openings which are formed in a ground pattern provided on the underside of a substrate. This circuit is not hermetically sealed and does not have a dielectric resonator.

It is therefore an object of the present invention to provide a simple and reliable dielectric-controlled integrated oscillator. This object is solved by a microwave oscillator according to claim 1.

In accordance with the present invention, a substrate made of a material having a high dielectric constant is mounted on a bottom internal surface of a hermetically sealed metal package, while carrying thereon a microwave active element chip and a dielectric resonator. A threaded hole extends throughout the bottom wall of the package from the outside to the inside in alignment with the position of the dielectric resonator on the substrate. A metal screw is engaged in the threaded hole from outside the package. The screw may be turned to vary the distance between it and the dielectric resonator to adjust the oscillation frequency.

The above and other objects, features and advantages of the present invention will become more apparent from the following detailed description taken with the accompanying drawing.

### Brief description of the drawing

Fig. 1A is a plan view of an internal structure of a prior art dielectric-controlled integrated oscillator viewed from the above;

Fig. 1B is a section along line A-A' of Fig. 1A and viewed in a direction indicated by an arrow;

Fig. 2 is a fragmentary sectional side elevation of a modification to the prior art oscillator shown in Figs. 1A and 1B;

Fig. 3A is a plan view of an internal structure of a dielectric-controlled integrated oscillator embodying the present invention viewed from above;

Fig. 3B is a sectional side elevation along line B-B' of Fig. 3A and viewed in a direction indicated by an arrow;

Fig. 3C is a bottom view showing the back of a substrate have a high dielectric constant which is included in the oscillator of Figs. 3A and 3B;

Fig. 3D is an equivalent circuit of the substrate included in the oscillator of Figs. 3A-3C; and

Figs. 4 and 5 are views representative of a relationship between an oscillation frequency of the oscillator shown in Figs. 3A—3D and a position of a screw adapted for frequency adjustment.

### Description of the preferred embodiment

While the microwave oscillator of the present invention is susceptible of numerous physical embodiments, depending upon the environment and requirements of use, a substantial number of the herein shown and described embodiments have been made, tested and used and all have performed in an eminently satisfactory manner.

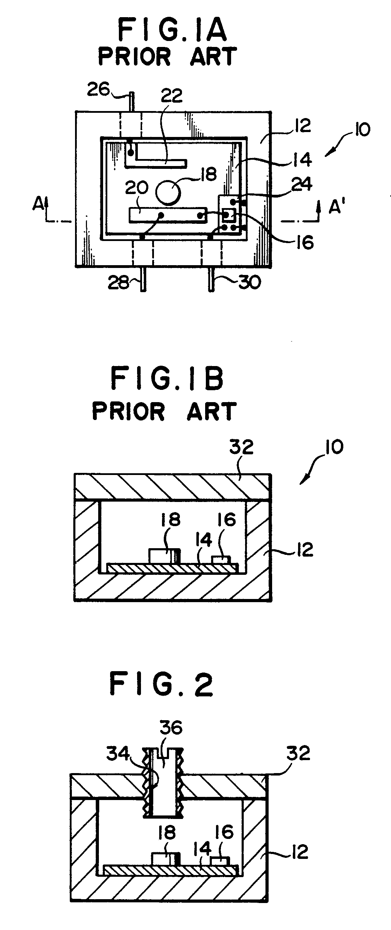

To facilitate understanding of the present invention, a brief reference will be made to prior art oscillators of the type concerned, shown in Figs. 1A and 1B and Fig. 2. Fig. 1 is a plan view of an internal arrangment of a prior art oscillator 10 viewed from the above, while Fig. 1B is a section along line A-A' of Fig. 1A. The ocillator 10 includes a metal chassis 12 and a substrate 14 mounted on a bottom wall of the chassis 12. The substrate 14 is made of alumina ceramic or like material having a high dielectric constant. Carried on the substrate 14 are a semiconductor active element chip 16, a dielectric resonator 18, a pattern 20 for electromagnetically coupling the chip 16 and resonator 18, a pattern 22 for leading out an output, and a pattern 24 for blazing the chip 16. A terminal 26 for picking up an oscillation output and terminals 28 and 30 for applying DC bias to the chip 16 extend out from the metal chassis 12. The top of the metal chassis 12 is closed by a metal cover plate 32 as shown in Fig 1B.

In the prior art oscillator construction described above, the semiconductor active element chip 16 comprises a GaAs FET chip a gate electrode of which is connected to the pattern 20 and a drain electrode, to ground. To protect the chip 16 from the atmospheric air, the chassis 12 and cover plate 32 are sealingly connected together as by soldering.

As previously described, the oscillation frequency of such a prior art oscillator cannot be adjusted when fluctuated after the oscillator per se is hermetically sealed. Also, a difficulty is experienced in setting up a necessary frequency before the hermetic sealing operation. In light of this, frequency adjustment may be implemented by, as shown in Fig. 2, forming a tapped through hole 34 in the cover plate 32 and fitting a metal screw 36 for frequency adjustment in the tapped hole 34. However, the tapped hole 34 in the cover plate 32 inevitably effects the sealed oscillator configuration to allow the semiconductor active element chip 16 to contact the atmospheric air, resulting in a significant fall of the reliability of operation.

A preferred embodiment of the present invention which is free from the drawbacks inherent in the prior art ocillators will now be described in detail.

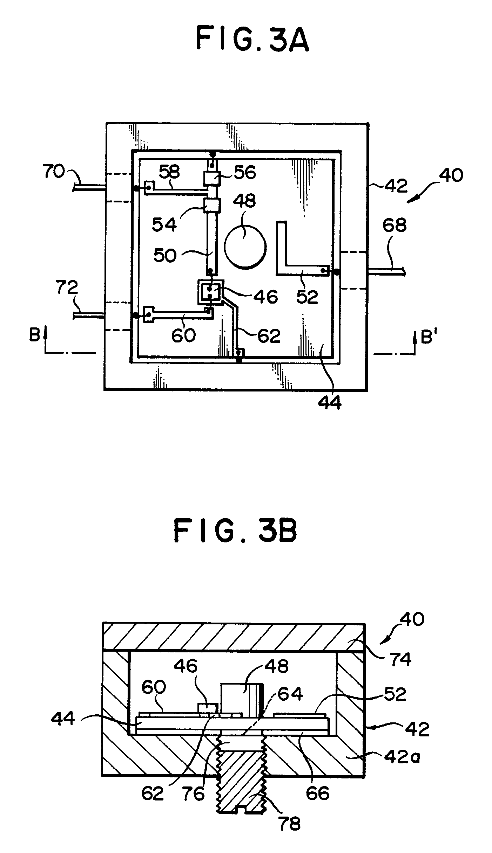

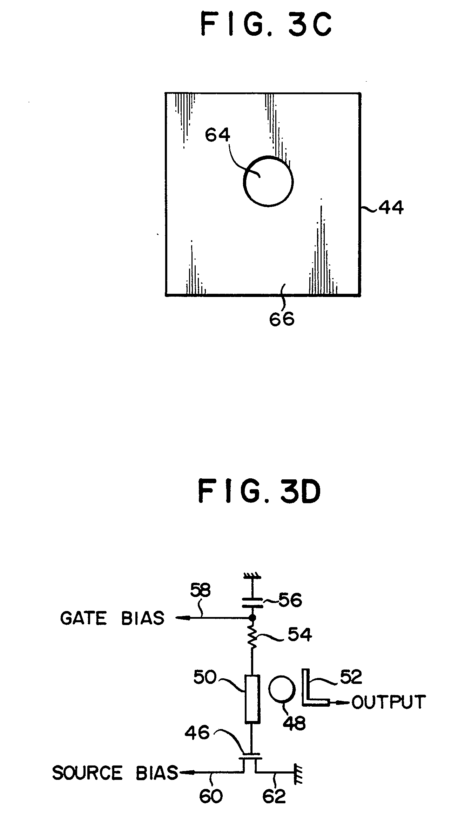

Fig. 3A is a plan view of an internal structure of a dielectric-controlled integrated oscillator 40 in accordance with the present invention viewed from above, while Fig. 3B is a sectional side elevation along line B-B' of Fig. 3A and viewed in a direction indicated by an arrow. In these drawings, a substrate 44 made of alumina ceramic or like material having a high dielectric constant is laid on a bottom wall 42a of a metal chassis 42. Carried on the surface of the substrate 44 are a semiconductor active element chip 46, which comprises a FET or the like, a dielectric resonator 48, a pattern 50 for magnetically coupling the chip 46 and the resonator 48, and a pattern 52 for leading out an output. The coupling pattern 50 is connected at one end to a gate of the chip 46 and at the other end to ground via a chip resistor 54 and a chip capacitor 56. A pattern 58 extends out from the junction between the chip resistor 54 and the chip capacitor 56 so as to apply gate bias to the chip 46. Source bias is applied to a source of the chip 46 via a pattern 60. Further, the chip 46 is connected to ground via a pattern 62. As shown in Fig. 3C, a ground pattern 66 is formed on the entire back surface of the substrate 44 except for a limited area 64 which aligns in position with the dielectric resonator 48, which is mounted on the other surface of the substrate 44. The substrate 44 contructed in the manner described is represented by an equivalent circuit in Fig. 3D.

As shown in Fig. 3A, the metal chassis 42 carries therewith a terminal 68 for picking up an oscillation output, a gate bias supply terminal 70 connecting to the pattern 58, and a source bias supply terminal 72 connecting to the pattern 60. As shown in Fig. 3B, the top of the metal chassis 42 is closed by a metal cover plate 74 and soldered or otherwise sealingly connected thereto.

As shown in Fig. 3B, a bottom wall 42a of the metal chassis 42 of the oscillator in accordance with the present invention is formed somewhat thicker than the other walls. A tapped through hole 76 is formed in an intermediate portion of the thicker bottom wall 42a corresponding to the specific area 64 of the back of the substrate 44 which lacks the ground pattern, that is, aligning with the dielectric resonator 48. The tapped hole 76 receives therein a metal or dielectric screw 78 adapted for frequency adjustment. In this construction, part of an electromagnetic field developed by the dielectric resonator 48 leaks into the tapped hole 76, so that the oscillation frequency is adjustable by changing the position of the metal screw 78 in the tapped hole 76, i.e. depth of the tapped hole 76.

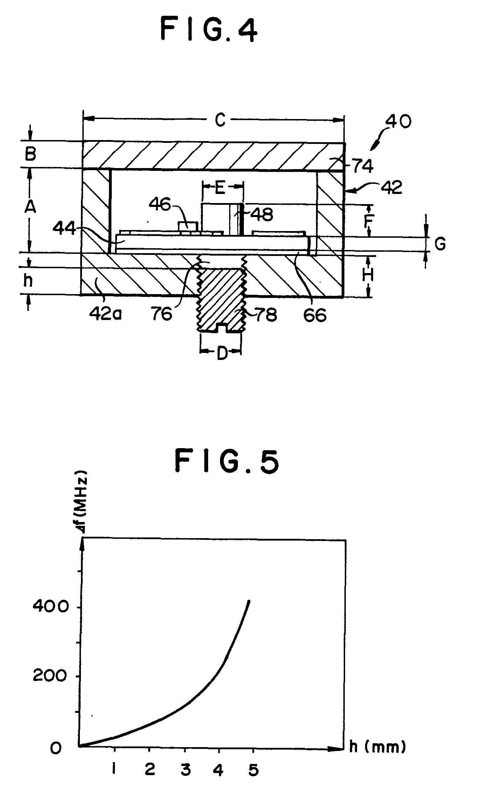

Referring to Figs. 4 and 5, a relationship between a position of the frequency adjusting screw 78 and an oscillation frequency is shown. In Fig. 4, let it be assumed that the metal chassis 42 has a depth A which is 8 mm, the cover plate 74 has a thickness B which is 5 mm and a length C which is 19 mm, the screw 78 has a diameter D which is 5.5 mm, the dielectric resonator 48 has a diameter E which is equal to the diameter D, i.e. 5.5 mm, and a height F which is 2.2 mm, the substrate 44 has a thickness G which is 0.635 mm, the bottom wall of 42a of the metal chassis 42 has a thickness H which is common to the thickness B, i.e. 5 mm, the distance between the bottom wall 42a and the engaged portion of the screw 78, i.e. position of the screw 78, is $h$, and the oscillation center frequency $f_o$ is 11.0 GHz. Then, a relation holds between the position $h$ (mm) of the frequency adjusting screw 78 and the oscillation frequency $\Delta f$ (MHz) as represented by a curve in Fig. 5.

In the embodiment described above, electromagnetic shield is maintained by the metal chassis 42 and screw 78 substantially eliminating the fear that the no-load Q of the dielectric resonator should be lowered by radiator loss. Also, the various elements housed in the oscillator are hermetically confined therein by the metal chassis 42, cover plate 74 and substrate 44 and, therefore the semiconductor active element chip 46 is free from the influence of the atmospheric air.

In summary, it will be seen that the present invention provides a microwave oscillator which not only insures reliability of a semiconductor chip installed therein by sealingly isolating it from the atmospheric air, but also allows its oscillation frequency to be adjusted with ease and accuracy by a simple arrangement even after the hermetic isolation.

Various modifications will become possible for those skilled in the art after receiving the teachings of the present disclosure without departing from the scope thereof.

**Claims**

1. A microwave oscillator having a semiconductor active element (46) and using a dielectric resonator (48) as a frequency stabilising element and a line pattern (50, 52, 58, 60, 62) electromagnetically coupling the active element (46) and the resonator (18), comprising

a) a housing (42) having an internal space which is defined by a plurality of walls and kept in a hermetically sealed condition;

b) a substrate (44) carrying the dielectric resonator (48) electromagnetically coupled with the active element (46);

c) oscillation frequency adjusting means (78) arranged in the housing (42) with a predetermined positional relationship to the dielectric resonator (48) for adjusting the oscillation frequency, characterized in that

d) the substrate (44) having a high dielectric constant is mounted on a surface of a predetermined wall (42a) inside the housing (42), wherein the dielectric resonator (48), the active element (46) and the line pattern (50, 52, 58, 60, 62) are provided on the substrate (44);

e) a ground pattern (66) having an opening area (64) which is aligned with the resonator (48) is provided on the bottom of the substrate (44); and that

f) the oscillation frequency adjusting means (78) is provded on the housing wall which adjoins the lower surface of the substrate (44) and is aligned with the resonator (48) and with the opening area (64) of the ground pattern (66).

2. A microwave oscillator as claimed in claim 1, in which the oscillation frequency adjusting means (78) is arranged in said predetermined wall (42a), the substrate (44) constituting part of said predetermined wall (42a) to maintain the internal space of the housing (42) hermetically sealed.

3. A microwave oscillator as claimed in claim 1 or 2, in which the oscillation frequency adjusting means (78) comprises a threaded through hole (76) extending in said predetermined wall (42a) from outside the housing (42) to inside, said through hole (76) being closed by the substrate (44) from inside the housing (42), and a screw (78) received in said threaded hole (76), whereby the screw (78) is turned to vary a distance between the screw (78) and the dielectric resonator (48) and, thereby, the oscillation frequency.

4. A microwave oscillator as claimed in claim 3, in which the walls of the housing (42) and the screw (76) are made of metal.

5. A microwave oscillator as claimed in claim 3, in which the screw (78) is made of a dielectric.

6. A microwave oscillator as claimed in any of claims 1 to 5, in which said predetermined wall (42a) is a bottom wall.

**Patentansprüche**

1. Mikrowellenoszillator mit einem aktiven Halbleiterelement (46) und einem dielektrischen Resonator (48) als frequenzstabilisierendes Element sowie mit einem Leitungsmuster (50, 52, 58, 60, 62), das das aktive Element (46) und den Resonator (48) elektromagnetisch koppelt,

a) einem Gehäuse (42), dessen Innenraum durch mehrere Wände definiert und in hermetisch abgedichtetem Zustand gehalten wird;

b) einem Substrat (44), auf dem der dielektrische Resonator (48) angeordnet ist, der mit dem aktiven Element (46) elektromagnetisch gekoppelt ist; und mit

c) einer Einstelleinrichtung (78) für die Schwingungsfrequenz, die in vorgegebener Relativlage zum dielektrischen Resonator (48) in dem Gehäuse (42) angeordnet ist, um die Schwingungsfrequenz einzustellen, dadurch gekennzeichnet, daß

d) das Substrat (44) eine hohe dielektrische Konstante aufweist und auf einer Oberfläche einer vorgegebenen Wand (42a) innerhalb des Gehäuses (42) angeordnet ist, wobei der dielektrische Resonator (48), das aktive Element (46) und das Leitungsmuster (50, 52, 58, 60, 62) auf dem Substrat (44) vorgesehen sind;

e) ein Massemuster (66) mit einem Öffnungsbereich (64), der mit dem Resonator (48) ausgerichtet ist, auf dem Boden des Substrats (44) vorgesehen ist; und daß

f) die Einstelleinrichtung (78) für die Schwingungsfrequenz auf der Gehäusewand vorgesehen ist, die an die Unterseite des Substrats (44) anschließt, und mit dem Resonator (48) und mit dem Öffnungsbereich (64) des Massemusters (66) ausgerichtet ist.

2. Mikrowellenoszillator nach Anspruch 1, wobei die Einstelleinrichtung (78) für die Schwingungsfrequenz in der vorgegebenen Wand (42a) angeordnet ist, wobei das Substrat (44) einen Teil der vorgegebenen Wand (42a) bildet, um den Inneraum des Gehäuses (42) hermetisch abzudichten.

3. Mikrowellenoszillator nach Anspruch 1 oder 2, wobei die Einstelleinrichtung (78) für die Schwingungsfrequenz eine durchgehende Gewindebohrung (76) aufweist, die sich in der vorgegebenen Wand (42a) von außerhalb des Gehäuses (42) ins innere erstreckt, wobei die durchgehende Bohrung (76) durch das Substrat (44) auf der Innerseite ges Gehäuses (42) abgeschlossen und eine Schraube (78) in der Gewindebohrung (76) aufgenommen wird, wobei die Schraube (78) verdrehbar ist, um den Abstand zwischen der Schraube (78) und dem dielektrischen Resonator (48) und damit die Schwingungsfrequenz zu variieren.

4. Mikrowellenoszillator nach Anspruch 3, wobei die Wände des Gehäuses (42) und die Schraube (76) aus Metall bestehen.

5. Mikrowellenoszillator nach Anspruch 3, wobei die Schraube (78) aus einem Dielektrikum besteht.

6. Mikrowellenoszillator nach einem der Ansprüche 1 bis 5, wobei die vorgegebene Wand (42a) eine Bodenwand ist.

**Revendications**

1. Un oscillateur à micro-ondes comportant un élément actif à semi-conducteur (46) et utilisant un résonateur diélectrique (48) comme élément stabilisateur de fréquence et un élément de ligne (50, 52, 58, 60, 62) couplé d'une manière électromagnétique avec l'élément actif (46) et le résonateur (48) et comprenant

a) un boîtier (42) comportant un espace intérieur qui est défini par une pluralité de cloisons et qui est conservé dans des conditions d'étanchéité hermétique;

b) un substrat (44) portant le résonateur diélectrique (48) couplé d'une manière électromagnétique avec l'élément actif (46) ; et

c) des moyens d'ajustement de la fréquence d'oscillation (78) disposées dans le boîtier (42) avec une position prédéterminée en relation avec le résonateur diélectrique (48) pour permettre l'ajustement de l'oscillation de fréquence d'oscillation, caractérisé en ce que

d) le substrat (44) présentant une constante diélectrique élevée est monté à la surface d'une paroi prédéterminée (42a) à l'intérieur du boîtier (42) dans lequel le résonateur diélectrique (48), l'élément actif (46) et les éléments de ligne (50, 52, 58, 60, 62) sont fixés sur le substrat (44);

e) un élément de mise à la masse (66) comportant une partie ouverte (64) qui est alignée avec le résonateur (48) et prévue à la base du substrat (44); et en ce que

f) le moyen d'ajustement de la fréquence d'oscillation (78) est prévu sur la paroi du boîtier qui est au contact de la face inférieure du substrat (44) et est aligné avec le résonateur (48) et avec la partie ouverte (64) de l'élément de mise à la mass (66).

2. Un oscillateur à micro-ondes tel que revendiqué à la revendication 1, dans lequel le moyen d'ajustement de la fréquence d'oscillation (78) est disposé sur ladite paroi prédéterminée (42a), le substrat (44) étant un élément constituant de la paroi prédéterminée (42a) qui maintient l'espace intérieur du boîtier (42) hermétiquement fermé.

3. Un oscillateur à micro-ondes tel que revendiqué aux revendications 1 ou 2, dans lequel le moyen d'ajustement de la fréquence d'oscillation (78) comprend un trou taraudé (76) s'étendant au travers de ladite paroi prédéterminée (42a) à partir de l'extérieur du boîtier (42) jusqu'à l'intérieur, ledit trou taraudé (76) étant proche du substrat (44) à l'intérieur du boîtier (42), et la vis (78) placée dans ledit trou taraudé (76), dans lequel elle est vissée pour faire varier la distance entre la vis (78) et les résonateur diélectrique (48) et, par ce moyen, la fréquence d'oscillation.

4. Un oscillateur à micro-ondes tel que revendiqué à la revendication 3, dans lequel les parois du boîtier (42) et la vis (76) sont fabriqués en métal.

5. Un oscillateur à micro-ondes tel que revendiqué à la revendication 3, dans lequel la vis (78) est fabriquée d'une matière isolante.

6. Un oscillateur à micro-ondes tel que revendiqué dans l'une quelconque des revendications 1 à 5, dans lequel ladite paroi prédéterminée (42a) est une paroi de fond.

# FIG.IA
## PRIOR ART

# FIG.IB
## PRIOR ART

# FIG. 2

# FIG. 3A

# FIG. 3B

# FIG. 3C

# FIG. 3D

# FIG.4

# FIG.5